Europäisches Patentamt

European Patent Office

Office européen des brevets

(11) Veröffentlichungsnummer: **0 316 667**
**A2**

(12) **EUROPÄISCHE PATENTANMELDUNG**

(21) Anmeldenummer: 88118319.8

(22) Anmeldetag: 03.11.88

(51) Int. Cl.⁴: **G03F 7/08**

(30) Priorität: 13.11.87 DE 3738603

(43) Veröffentlichungstag der Anmeldung:
24.05.89 Patentblatt 89/21

(84) Benannte Vertragsstaaten:
**AT CH DE FR GB IT LI NL SE**

(71) Anmelder: **CIBA-GEIGY AG**
**Klybeckstrasse 141**
**CH-4002 Basel(CH)**

(72) Erfinder: **Raulin, Dietmar**
**Odenwaldstrasse 33**
**D-6141 Einhausen(DE)**
Erfinder: **Wächtler, Andreas, Dr.**
**Goethestrasse 34**
**D-6103 Griesheim(DE)**
Erfinder: **Neisius, Karl Heinz, Dr.**
**Kattreinstrasse 76**
**D-6100 Darmstadt(DE)**

(54) **Lagerstabile Positiv-Fotoresist-Zusammensetzungen.**

(57) Die Erfindung betrifft Positiv-Fotoresist-Zusammensetzungen, die zur Steigerung ihrer Lagerstabilität mindestens eine Verbindung aus der Gruppe der primären, sekundären und tertiären niederaliphatischen Aminoverbindungen oder Pyridin enthalten.

EP 0 316 667 A2

## Lagerstabile Positiv-Fotoresist-Zusammensetzungen

Die Erfindung betrifft Positiv-Fotoresist-Zusammensetzungen, die zur Steigerung ihrer Lagerstabilität mindestens eine Verbindung aus der Gruppe der tertiären niederaliphatischen und cycloaliphatischen Aminoverbindungen oder Pyridin enthalten.

Die Herstellung von Halbleiterbauelementen und integrierten Schaltungen in der Mikroelektronik erfolgt praktisch ausschließlich unter Anwendung photolithographischer Strukturierungsprozesse. Zur Herstellung von bestimmte Schaltungsstrukturen aufweisenden Mikrochips wird das Halbleitersubstratmaterial, im allgemeinen sind das Siliziumscheiben, mit Fotolack beschichtet und durch bildmäßiges Belichten und anschließendes Entwickeln werden hierauf Fotoresist-Reliefstrukturen erzeugt. Diese dienen als Maske für die eigentlichen Strukturierungsprozesse am Halbleitersubstrat wie Ätzen, Dotieren, Beschichten mit Metallen, anderen Halbleiter- oder auch Isolatormaterialien. Nach diesen Prozessen werden die Fotoresist-Masken je nach Bedarf wieder entfernt. Durch eine Vielzahl derartiger Prozeßzyklen entstehen auf dem Substrat die Schaltungsstrukturen der Mikrochips.

Es werden grundsätzlich zwei verschiedene Typen von Fotoresists unterschieden: Bei positiv arbeitenden Fotoresists werden die belichteten Bereiche durch einen Entwicklungsprozeß abgelöst, während die unbelichteten Bereiche als Schicht auf dem Substrat verbleiben. Bei negativ arbeitenden Fotoresists verbleiben umgekehrt die bestrahlten Schichtbereiche als Reliefstruktur. Positiv-Fotoresists besitzen von ihrer Natur her eine höhere Bildauflösung und werden deshalb überwiegend bei der Herstellung von VLSI-Schaltungen eingesetzt.

Positiv-Fotoresist-Zusammensetzungen üblicher Art enthalten in einem organischen Lösungsmittel im wesentlichen mindestens je ein in wäßrigen Alkalien lösliches Harz und eine fotoempfindliche Chinondiazidverbindung, die die Alkalilöslichkeit des Harzes reduziert. Durch Strahlungseinwirkung auf mit derartigen Zusammensetzungen erzeugte Fotoresistschichten wird die Alkalilöslichkeit in den belichteten Bereichen durch fotoinduzierte strukturelle Umwandlung der Chinondiazidverbindung in ein Carbonsäurederivat erhöht, sodaß nach Entwicklung in wäßrig-alkalischen Entwicklungsbädern positive Fotoresist-Reliefstrukturen erhalten werden.

Die ständig fortschreitende Miniaturisierung in der Halbleitertechnologie und Mikroelektronik stellt an die Fotoresist-Materialien und die damit darzustellenden Reliefstrukturen höchste Anforderungen. Neben Empfindlichkeit, Auflösung und Kontrast des Fotoresist sowie Haftfestigkeit, mechanischer und chemischer Stabilität, Dimensionstreue und Beständigkeit bei erhöhten Temperaturen oder anderen Einflüssen, die bei den weiteren Prozeßschritten auf die Fotoresist-Reliefstrukturen einwirken können, kommt der Partikelfreiheit der Fotoresistlösung für die praktische Anwendbarkeit in der Mikroelektronik entscheidende Bedeutung zu.

Feststoffpartikel wie allgegenwärtige Staubteilchen oder Partikel, die durch lagerbedingte Veränderungen in der Fotoresistlösung entstehen, führen, insbesondere, wenn deren Dimension in der Größenordnung der abzubildenden Strukturen oder darüber liegt , zu unerwünschten Ausbeuteverlusten an funktionsfähigen Mikrochips durch das Auftreten der sogenannten "black spots".

Zur Entfernung von Feststoffpartikeln werden die fertigen Fotoresistlösungen üblicherweise vor der Abfüllung einer Feinfiltration durch Membranfilter mit Porenweiten, je nach Bedarf, zwischen 0,1 und 1 μm unterzogen. Lagerbedingte Veränderungen, die zu Feststoffpartikelausscheidungen in der Fotoresistlösung führen, werden überwiegend durch unkontrollierte Zersetzung im Anteil an fotoempfindlicher Chinondiazid-Verbindung verursacht. Derartige Zersetzungsvorgänge treten vielfach in unterschiedlichem, meist nicht reproduzierbarem Umfang auf und sind, trotz größtmöglicher Standardisierung bei der Herstellung sowohl der Ausgangsstoffe als auch des Fotoresist, produktions- und chargenbedingt. Vermutungen in der Fachwelt zufolge, sollen diese Zersetzungsvorgänge durch Restverunreinigungen basischer Natur ausgelöst werden. Zur Stabilisierung von Positiv-Fotoresistlösungen wurde deshalb verschiedentlich versucht, basische Anteile zu neutralisieren, etwa durch Behandlung mit sauren Ionenaustauschern. Der Stabilisierungseffekt ist jedoch vielfach ungenügend.

Deshalb ist es angezeigt, nach längerer Lagerung die Fotoresistlösung direkt vor der Anwendung erneut einer Feinfiltration zu unterziehen. Braun gefärbte Filter sind ein sicheres Anzeichen für Zersetzung von Chinondiazid-Verbindung und für das Auftreten von die Chipausbeute vermindernden "black spots".

Es bestand daher die Aufgabe, Additive für Positiv-Fotoresists aufzufinden, die die Zersetzung im Anteil an Chinondiazid-Verbindung und das Auftreten von "black spots" deutlich reduzieren oder gänzlich verhindern und somit die Lagerstabilität verbessern. Die übrigen Eigenschaften des Fotoresists sollten im übrigen unverändert bleiben. Weiterhin sollten Positiv-Fotoresistformulierungen die solche Additive enthalten, entwickelt werden, die eine verbesserte Lagerstabilität aufweisen und dementsprechend üblichen Fotoresists überlegen sind.

Überraschend wurde nun gefunden, daß Zusätze basischer Natur, nämlich Verbindungen aus der Gruppe der primären, sekundären und tertiären niederaliphatischen Aminoverbindungen oder Pyridin vorzüglich als derartige Additive geeignet sind.

Gegenstand der Erfindung sind somit lagerstabile Positiv-Fotoresist-Zusammensetzungen, enthaltend in einem organischen Lösungsmittel im wesentlichen mindestens je

a) ein alkalilösliches Harz
b) eine fotoempfindliche Chinondiazid-Verbindung

sowie gegebenenfalls weitere übliche Zusatzstoffe, in denen mindestens eine Verbindung aus der Gruppe der primären, sekundären und tertiären niederaliphatischen Aminoverbindungen oder Pyridin in einem die Lagerstabilität steigernden Anteil enthalten ist.

Gegenstand der Erfindung ist weiterhin die Verwendung von Verbindungen aus der Gruppe der primären, sekundären und tertiären niederaliphatischen Aminoverbindungen oder Pyridin als Additive zur Steigerung der Lagerstabilität von Positiv-Fotoresist-Zusammensetzungen auf Basis alkalilöslicher Harze und lichtempfindlicher Chinondiazid-Verbindungen.

Gegenstand der Erfindung ist darüber hinaus ein Verfahren zur Stabilisierung von Positiv-Fotoresist-Zusammensetzungen auf Basis alkalilöslicher Harze und lichtempfindlicher Chinondiazid-Verbindungen, wobei man ihnen eine wirksame Menge mindestens einer Verbindung aus der Gruppe der primären, sekundären und tertiären niederaliphatischen Aminoverbindungen oder Pyridin zusetzt.

Die erfindungsgemäßen lagerstabilen Positiv-Fotoresist-Zusammensetzungen entsprechen bezüglich der Hauptkomponenten im wesentlichen den bekannten und handelsüblichen Positiv-Fotoresists. Sie enthalten in einem organischen Lösungsmittel ein alkalilösliches Harz, eine fotoempfindliche Chinondiazid-Verbindung und gegebenenfalls weitere übliche Zusatzstoffe, mit denen die Eigenschaften des Fotoresist auf die spezifischen Anforderungen der Einsatzzwecke eingestellt werden können.

Erfindungsgemäß enthalten die Positiv-Fotoresist-Zusammensetzungen zur Steigerung der Lagerstabilität mindestens eine Verbindung aus der Gruppe der primären, sekundären und tertiären niederaliphatischen Aminoverbindungen oder Pyridin.

Primäre, sekundäre und tertiäre niederaliphatische Verbindungen sind solche, in denen eine, zwei oder drei Valenzen des Aminostickstoffatoms durch niederaliphatische Reste besetzt sind. Unter niederaliphatischen Resten sind vornehmlich Alkylgruppen mit 1 bis 6 Kohlenstoffatomen zu verstehen, weiterhin Cycloalkylgruppen mit 5 bis 7 Kohlenstoffatomen sowie Cycloalkylengruppen mit 4 bis 6 Kohlenstoffatomen, die mit dem Stickstoffatom einen Ring bilden. Beispiele für derartige Niederalkylreste sind etwa Methyl, Ethyl, n- und i-Propyl, n-, iso-, sekundäres und t-Butyl, Pentyl und Hexyl jeweils in ihren isomeren Formen, Cyclopentyl, Cyclohexyl, Cycloheptyl, 1,4-Butylen, 1,5-Pentylen, 1,6-Hexylen.

Primäre Aminoverbindungen als Additive im Sinne der Erfindung sind beispielsweise Methylamin, Ethylamin, n- und i-Propylamin, n-Pentylamin, n-Hexylamin, Cyclohexylamin. Als sekundäre Amine sind etwa zu nennen Dimethylamin, Diethylamin, Diisopropylamin, cyclische Amine wie Pyrrolidin und Piperidin. Auch sind sekundäre Amine mit unterschiedlichen Alkylresten möglich, wie etwa Methylethylamin.

Tertiäre Amine sind beispielsweise Trimethylamin, Triethylamin, Tri-n- oder -i-propylamin, Tributylamin, Methyldiethylamin, N-Methylpyrrolidin, N-Methylpiperidin.

Pyridin ist ebenfalls ein gut geeignetes Additiv im Sinne der Erfindung.

Besonders bevorzugte erfindungsgemäße Additive sind tertiäre Aminoverbindungen wie insbesondere Triethylamin, Triisopropylamin und Pyridin.

Als besonders überraschend stellte sich heraus, daß die erfindungsgemäßen Additive in Positiv-Fotoresist-Zusammensetzungen im Falle längerer Lagerung, insbesondere auch bei höherer Temperatur, in äußerst wirksamer Weise die Zersetzung von Chinondiazid und die damit verbundene Bildung von Feststoffpartikeln verhindern. Die Gefahr der Bildung von die Chipausbeute vermindernden "black spots" wird durch die erfindungsgemäßen Additive drastisch reduziert. Die stabilisierende Wirkung der Additive läßt sich in einfacher Weise daran erkennen, daß bei einer nochmaligen Feinfiltration einer entsprechenden Fotoresistlösung nach längerer Lagerung das Filter keine Verfärbung aufweist. Die erfindungsgemäßen Additive sind schon in verhältnismäßig geringer Konzentration wirksam. Im allgemeinen ist ein Gehalt von 1 bis 10000 ppm, bezogen auf die Gesamtmenge an Fotoresistlösung, ausreichend. Vorzugsweise werden die erfindungsgemäßen Additive in einem Anteil von 500 bis 5000 ppm, bezogen auf die Gesamtmenge, eingesetzt.

Eine Veränderung der sonstigen anwendungstechnischen Eigenschaften der Fotoresists durch die erfindungsgemäßen Additive ist hierbei nicht zu beobachten.

Die erfindungsgemäßen lagerstabilen Positiv-Fotoresist-Zusammensetzungen enthalten als Harzkomponente alkalilösliche Harze wie zum Beispiel Novolak-Harze, die durch Kondensation von Phenol bzw. phenolischen Verbindungen mit Aldehyden erhalten werden. Bevorzugt sind Kresol-Formaldehyd-Harze, zu deren Herstellung o-, m-, p-Kresol oder Mischungen dieser Isomeren in beliebigen oder vorbestimmten Verhältnissen eingesetzt werden. Die Herstellung solcher Harze und ihr Einsatz in Positiv-Fotoresists ist z.B. in US-Patent 4,377,631 beschrieben. In Positiv-Fotoresist-Zusammensetzungen ist die Harzkomponente üblicherweise in einem Anteil von etwa 50-95 Gew.%, bezogen auf den Gesamtfeststoffgehalt der Fotoresist-Lösung, enthalten.

Außerdem kommen auch andere alkalilösliche Harze in Frage, wie sie vielfach in Positiv-Fotoresists verwendet werden. Dazu gehören etwa Poly-Vinylphenole und Poly-Glutarimide, Copolymere aus Styrol und α-Methylstyrol mit Maleinimid sowie Copolymere aus N-(p-Hydroxyphenyl)maleinimid und Olefinen. Weiterhin können auch silylierte Derivate alkalilöslicher Polymere verwendet werden, die eine höhere Plasmaätzbeständigkeit aufweisen.

Als fotoempfindliche Chinondiazidverbindungen sind in Positiv-Fotoresists bevorzugt Veresterungsprodukte der 1,2-Naphthochinon-2-diazid-5-sulfonsäure oder 1,2-Naphthochinon-2-diazid-4-sulfonsäure mit niedermolekularen aromatischen oder aliphatischen Hydroxyverbindungen enthalten. Derartige Naphthochinondiazidsulfonsäureester sind beispielsweise in den US-Patentschriften 3,046,112, 3,106,462, 3,148,983 und 3,201,239 sowie in EP 0085761 beschrieben. Überwiegend sind in Positiv-Fotoresists als lichtempfindliche Komponenten Naphthochinondiazidsulfonsäureester von Hydroxybenzophenonen wie insbesondere 2,3,4-Trihydroxybenzophenon im Gebrauch. Vorteilhaft sind auch die entsprechenden Ester mehrfach hydroxylierter Benzole, wie etwa die Isomeren von Trihydroxybenzol, insbesondere 1,3,5-Trihydroxybenzol. Gelegentlich werden auch oligomere oder polymere Naphthochinondiazidverbindungen eingesetzt, in denen etwa der Naphthochinondiazidsulfonylrest mit freien Hydroxyl-Gruppen von Phenolformaldehydkondensaten, also beispielsweise denen des Novolak-Harzes selbst, verestert ist. Von den lichtempfindlichen Naphthochinondiazidverbindungen sind überwiegend die 5-Sulfonsäureester im Gebrauch. Diese verfügen über eine breite Absorption im nahen bis mittleren UV-Wellenlängenbereich mit Maxima bei etwa 400 nm und etwa 340 nm. In diesem Wellenlängenbereich liegen kräftige Emissionslinien der üblicherweise in den Projektionsgeräten eingesetzten Quecksilberlampen, wie etwa die Linien bei 334 nm, 365 nm und 405 nm. Die 4-Sulfonsäureester verfügen über Absorptionsmaxima bei ca. 380 nm und um 300 nm und sind daher mehr für mittlere bis kurzwelligere UV-Strahlung geeignet, beispielsweise die Quecksilberemissionslinie bei 313 nm. Die Chinondiazidverbindungen sind in Positiv-Fotoresists üblicherweise in einem Anteil von etwa 5-50 Gew.%, bezogen auf den Gesamtfeststoffgehalt der Fotoresist-Lösung, enthalten.

Andere Chinondiazidverbindungen, die verwendet werden können, sind zum Beispiel monomere und dimere 2-Diazo-1,3-diketone, α-Phosphoryldiazocarbonylverbindungen sowie Benzochinondiazid-Derivate.

Als Lösungsmittel zur Herstellung der Fotoresist-Lösung sind im Prinzip alle Lösungsmittel geeignet, in denen die festen Fotoresist-Bestandteile wie alkalilösliches Harz, Chinondiazidverbindungen und gegebenenfalls weitere Zusatzstoffe ausreichend löslich sind und die mit diesen Bestandteilen nicht irreversibel reagieren. In Frage kommen hierfür beispielsweise aliphatische Ketone wie Methylethylketon oder Cyclohexanon, aliphatische Ester wie Butylacetat, Ether wie Tetrahydrofuran, Alkohole wie n- oder i-Propanol, Mono- oder Bisether sowie gemischte Ether-Esterderivate von Glycolverbindungen wie von Ethylenglycol, Diethylenglycol oder Propylenglycol, des weiteren Monooxocarbonsäureester wie etwa Milchsäureethylester oder 2-Ethoxypropionsäureethylester. Aliphatische und aromatische Kohlenwasserstoffe wie n-Hexan und Xylol finden ebenfalls Verwendung als Lösungsmittel. Vielfach werden auch Gemische aus den genannten Lösungsmitteln verwendet. Verbreitet enthalten Fotoresist-Lösungsmittel Ethoxyethylacetat, Propylenglycolmethyletheracetat oder Ethylenglycoldimethylether. Das Lösungsmittel hat üblicherweise einen Anteil von 40-90 Gew.% an der gesamten Fotoresist-Lösung.

Zu den weiteren üblichen Zusatzstoffen, die auch in den erfindungsgemäßen lagerstabilen Fotoresist-Zusammensetzungen enthalten sein können, gehören die Fotoempfindlichkeit und/oder die Entwicklungsrate steigernde Verbindungen, etwa aromatische Hydroxyverbindungen wie Polyhydroxybenzophenone oder Benzotriazolderivate, sowie streustrahlungsabsorbierende Substanzen und Farbstoffe, Verlaufmittel, Weichmacher, Haftvermittler, weitere filmbildende Harze, Tenside und Stabilisatoren. Zusätze dieser Kategorien sind dem Fachmann ausreichend bekannt und sind vielfältig in der einschlägigen Fachliteratur beschrieben. Der Anteil an solchen Zusätzen übersteigt zusammengenommen kaum 25 Gew.%, bezogen auf den Gesamtfeststoffgehalt der Fotoresist-Lösung.

Die erfindungsgemäßen lagerstabilen Fotoresist-Zusammensetzungen enthalten typischerweise 50-90 Gew.%, vorzugsweise 70-80 Gew.%, an alkalilöslichem Harz, 5-35 Gew.%, vorzugsweise 10-25 Gew.%, an Chinondiazidverbindungen und 0-25 Gew.%, vorzugsweise 5-10 Gew.%, an sonstigen Zusatzstoffen, jeweils bezogen auf den Gesamtfeststoffgehalt. Der Anteil an erfindungsgemäßem Additiv beträgt vorzugsweise etwa 1000 ppm, bezogen auf die Gesamtmenge.

Die Formulierung der erfindungsgemäßen Positiv-Fotoresist-Zusammensetzungen erfolgt in an sich bekannter Weise durch Mischen bzw. Lösen der Komponenten in dem Lösungsmittel bzw. Lösungsmittelgemisch, wobei die erfindungsgemäß einzusetzenden Additive zugesetzt werden. Gleichermaßen ist es möglich, fertigformulierte Positiv-Fotoresist-Zusammensetzungen, wie sie etwa im Handel sind, mit der entsprechenden Menge an Additiv zu versetzen. Nach Lösung der Bestandteile im Lösungsmittel wird die erhaltene Fotoresist-Lösung je nach Anspruch an die Partikelfreiheit durch Membranfilter mit einer Porenweite von 0,1-1 μm filtriert. Üblichweise wird der Gesamtfeststoffgehalt des Fotoresist auf die gewünschte Schichtdicke und Beschichtungsmethode abgestimmt.

Die Anwendung der erfindungsgemäßen lagerstabilen Positiv-Fotoresist-Zusammensetzungen erfolgt nach an sich bekannten Verfahren und mit den hierfür üblichen Prozeßgeräten. Zunächst wird die Fotoresist-Lösung auf das Substrat aufgebracht und getrocknet. Als Substrate fungieren überwiegend Halbleiterscheiben, wie z.B. Silizium-Wafer, die gegebenenfalls mit einer Schicht aus Siliziumdioxid, Siliziumnitrid oder Aluminium überzogen sind. Auch andere, bei der Herstellung miniaturisierter Schaltungen übliche Materialien wie Germanium, Galliumarsenid, Keramik mit gegebenenfalls Edelmetallbeschichtung kommen in Frage.

Die Beschichtung erfolgt üblicherweise durch Tauchen, Sprühen, Walzen oder Aufschleudern. Bei der letzteren, am häufigsten angewandten Beschichtungsmethode ist die resultierende Schichtdicke abhängig von der Viskosität der Fotoresist-Lösung, dem Feststoffgehalt und der Aufschleudergeschwindigkeit. Für den jeweiligen Fotoresist werden sogenannte Schleuderkurven ermittelt, aus denen sich die Resist-Schichtdicken in Abhängigkeit von Viskosität und Schleuderdrehzahl ermitteln lassen. Die Schichtdicken bei Positiv-Fotoresists liegen typisch im Bereich von 0,5-4 μm.

Nachdem der Fotoresist auf das Substrat aufgebracht worden ist, wird er normalerweise bei Temperaturen zwischen 70 °C und 130 °C vorgetrocknet. Dazu können Öfen oder Heizplatten (sogenannte "Hot Plates") verwendet werden. Die Trocknungszeit in Öfen liegt im Bereich von etwa 15-45 Minuten, auf Hot Plates im Bereich von etwa 0,5-4 Minuten. Vorzugsweise werden 0,5-2 μm dicke Resistschichten etwa 1 Minute bei etwa 100 °C auf der Hot Plate getrocknet.

Der getrocknete Fotoresist wird dann durch eine Maske hindurch bildmäßig belichtet, wobei Strahlung mit einer Wellenlänge im Bereich von etwa 300 nm bis 450 nm verwendet wird. Die Belichtung kann poly- oder monochromatisch erfolgen. Bevorzugt werden hierzu kommerziell erhältliche Geräte, wie z.B. Scanning-Projektions-Belichtungsgeräte, Kontakt- und Abstands-Belichtungsgeräte oder Wafer-Stepper eingesetzt.

Die mit dem Fotoresist beschichteten und belichteten Substrate werden schließlich mit einer wäßrig-alkalischen Entwicklerlösung, z.B. durch Tauchen oder Besprühen, entwickelt, bis in den belichteten Bereichen der Resist vollständig abgelöst ist. Es können verschiedene Entwicklerformulierungen verwendet werden, die entweder zur Klasse der metallionenhaltigen oder metallionenfreien Fotoresistentwickler gehören. Metallionenhaltige Entwickler sind wäßrige Lösungen von Natriumhydroxyd oder Kaliumhydroxid, die daüber hinaus pH-regulierende und puffernde Substanzen, wie Phosphate oder Silikate sowie Tenside und Stabilisatoren enthalten können. Metallionenfreie Entwickler sind wäßrige Lösungen von organischen Basen, wie z.B. Tetramethylammoniumhydroxyd oder Cholin. Die Entwicklungszeiten hängen von der Belichtungsenergie, Stärke des Entwicklers, Art des Entwickelns, der Vortrocknungstemperatur und der Entwicklertemperatur ab. Bei der Tauchentwicklung sind Entwicklungszeiten von etwa 1 Minute typisch. Die Entwicklung wird üblicherweise durch Eintauchen oder Besprühen mit deionisiertem Wasser gestoppt. An die Entwicklung schließt sich häufig eine Nachtrocknung bei etwa 120 °C bis 180 °C an.

Die mit den erfindungsgemäßen lagerstabilen Fotoresist-Zusammensetzungen hergestellten Reliefstrukturen zeigen analog zu entsprechenden nicht stabilisierten Zusammensetzungen eine vorzügliche Bildauflösung bis unter 1 μm bei hohem Kontrast, hoher Kantensteilheit und Kantenschärfe. Der Schichtdickenverlust in den unbelichteten Bereichen ist minimal. In den nachfolgenden Prozeßabläufen bei der Herstellung von integrierten Halbleiterschaltungen wie Ätzen mit Säure oder im Plasma, Dotieren oder Beschichten, zeigen sie hervorragende Eigenschaften und gewährleisten einen wirksamen Schutz der mit den Fotoresist-Reliefstrukturen abgedeckten Bereiche des Schichtträgers.

Aufgrund der Stabilisierung gegen zersetzungsbedingte Feststoffpartikelbildung ist ihr Wert in der praktischen Anwendung gegenüber üblichen Fotoresists erheblich verbessert.

Beispiel 1

Eine Fotoresist-Stammlösung wurde hergestellt mit der Zusammensetzung

30 Gew.% p-Kresol-Novolak

10 Gew.% 1,3,5-Benzol-tris-(6-diazo-5,6-dihydro-5-oxonaphthalinsulfonat)

60 Gew.% Diethylenglycoldimethylether.

Einem Teil dieser Lösung wurden 1000 ppm Triethylamin als Stabilisator zugesetzt. Diese Lösung und eine Vergleichsprobe der Stammlösung wurden durch einen Filter mit 0,2 μm Porenweite filtriert.

Proben der Stabilisator-haltigen Lösung und die Vergleichsprobe wurden dann 14 Tage bei 50 °C gelagert.

Danach wurden die Proben erneut durch einen 0,2 μm-Filter filtriert.

Ergebnis:

Die Filter der erfindungsgemäß stabilisierten Fotoresistlösungen zeigten keine Verfärbung während das Filter der Vergleichsprobe eine deutliche Braunfärbung aufwies.

Beispiel 2

Ein entsprechendes Ergebnis wurde erhalten mit 1000 ppm Triisopropylamin als Stabilisator.

Beispiel 3

Ein entsprechendes Ergebnis wurde erhalten mit 1000 ppm Pyridin als Stabilisator.

**Ansprüche**

1. Positiv-Fotoresist-Zusammensetzungen, enthaltend in einem organischen Lösungsmittel im wesentlichen mindestens je

a) ein alkalilösliches Harz
b) eine fotoempfindliche Chinondiazid-Verbindung

sowie gegebenenfalls weitere übliche Zusatzstoffe, dadurch gekennzeichnet, daß darin mindestens eine Verbindung aus der Gruppe der primären, sekundären und tertiären niederaliphatischen Aminoverbindungen oder Pyridin in einem die Lagerstabilität steigernden Anteil enthalten ist.

2. Positiv-Fotoresist-Zusammensetzungen nach Anspruch 1, dadurch gekennzeichnet, daß darin 1 bis 10 000 ppm, vorzugsweise 500 bis 5000 ppm, bezogen auf die Gesamtmenge, mindestens einer die Lagerstabilität steigernden Verbindung aus der Gruppe der primären, sekundären und tertiären niederaliphatischen Aminoverbindungen oder Pyridin enthalten sind.

3. Verwendung von Verbindungen aus der Gruppe der primären, sekundären und tertiären niederaliphatischen Aminoverbindungen oder Pyridin als Additive zur Steigerung der Lagerstabilität von Positiv-Fotoresist-Zusammensetzungen auf Basis alkalilöslicher Harze und lichtempfindlicher Chinondiazid-Verbindungen.

4. Verfahren zur Stabilisierung von Positiv-Fotoresist-Zusammensetzungen auf Basis alkalilöslicher Harze und lichtempfindlicher Chinondiazid-Verbindungen, dadurch gekennzeichnet, daß man ihnen eine wirksame Menge mindestens einer Verbindung aus der Gruppe der primären, sekundären und tertiären niederaliphatischen Aminoverbindungen oder Pyridin zusetzt.

5. Verfahren nach Anspruch 4, dadurch gekennzeichnet, daß man 1 bis 10 000 ppm, vorzugsweise 500 bis 5 000 ppm, bezogen auf die Gesamtmenge, mindestens einer Verbindung aus der Gruppe der primären, sekundären und tertiären niederaliphatischen Aminoverbindungen oder Pyridin zusetzt.

6. Verfahren nach Anspruch 5, dadurch gekennzeichnet, daß man Triethylamin, Triisopropylamin oder Pyridin zusetzt.